# EUROPEAN PATENT APPLICATION

(11) **EP 4 471 850 A1**
(43) Date of publication of application: **04.12.2024**
(21) Application number: 23176197.4
(22) Date of filing: 30.05.2023
(51) Int. Cl.: H01L 23/482, H01L 23/48

(54) **PATTERNING SEMICONDUCTOR DEVICES**

(71) Applicant: Nexperia B.V., 6534 AB Nijmegen (NL)
(72) Inventor: Yogeswaran, Nivasan, Manchester (GB); Cousins, Ian, Manchester (GB); Gajda, Mark Andrzej, Manchester (GB)
(74) Representative: Pjanovic, Ilija

(57) **Abstract**

A method of manufacturing a semiconductor device is disclosed, and a semiconductor device manufactured with same. A layer of metallic material is deposited onto a substrate, the layer having a top surface. At least an edge area of the layer is masked with a first lithography mask and metallic material is removed from the edge area according to the first mask, whereby a first portion of the edge area has a thickness intermediate the substrate and the layer top surface. The first portion of the edge area is masked with a second lithography mask and metallic material is removed from the first portion according to the second mask, whereby second portions of the edge area are free of deposited metallic material.

## Description

### FIELD OF INVENTION

The present invention relates to a method of manufacturing a semiconductor device.

### BACKGROUND TO INVENTION

Semiconductor devices, particularly Metal Oxide Semiconductor Field Effect Transistor ('MOSFET') devices, are predominantly designed as single-layer metallisation devices in order to maintain low manufacturing costs. The thickness of the metallisation layer is guided by bond-force considerations for wire-bonded devices, or by some aspect of spreading resistance for clip-bonded devices. For certain specific applications, for example power MOSFETs, the metallisation layer should be as thick as possible, for the device to exhibit both low on-resistance, Rds(on), and uniform current spreading.

However, while a thick metallisation layer is desirable electrically, it is sub-optimal in mechanical terms, because semiconductor devices are typically manufactured with a passivation layer such as Si₃N₄, SiO₂ or a combination thereof, to protect the device from environmental contamination and surface damage, but which is prone to cracking out of thermal or temperature cycling ('TMCL') reliability test, particularly in edge areas. Desirable electrical and mechanical properties of the metallisation layer are thus opposed one to another, as a low Rds(on) value requires a thick metal layer, but mechanical robustness of the passivation layer requires the least amount of topography and thus favours a thin metal layer.

Semiconductor devices are accordingly manufactured mostly using a single metal layer, the thickness of which is optimised for either low Rds(on) or for mechanical robustness with a thin layer and, more rarely, with dual-layer metallisation techniques as a compromise to try and satisfy both requirements.

However such dual-layer metallisation typically requires at least two additional lithography layers, to accommodate both the second metal layer and the contact formation, together with some form of chemical mechanical planarization (CMP) processing in order to maintain the topography as flat as possible, for mitigating cracking. The additional processing steps and costs associated with dual-layer metallisation are non-trivial.

### SUMMARY OF INVENTION

Aspects of the invention are set out in the accompanying claims, respectively aimed at various embodiments of a method of manufacturing semiconductor devices, and to semiconductor devices manufactured with same.

An aim of the present invention is to match the opposed requirements of low topography and thick metallisation layer in a semiconductor device configured with varying thicknesses of metallisation layer, using a single additional photolithography stage and removal, moreover without additional CMP processing.

Accordingly, in a first aspect, a method of manufacturing a semiconductor device is provided, which comprises steps of depositing a layer of metallic material onto a substrate, the layer having a top surface ; masking at least an edge area of the layer with a first lithography mask ; removing metal material from the edge area according to the first mask, whereby a first portion of the edge area has a thickness intermediate the substrate and the layer top surface ; masking the first portion of the edge area with a second lithography mask; and removing metal material from the first portion according to the second mask, whereby at least a second portion of the edge area is free of deposited metallic material.

According to this solution, areas of semiconductor devices requiring low resistance, such as their active area, can be configured with full metallisation thickness, whereas areas of semiconductor devices sensitive to topography, such as their edge termination, can be configured with reduced metallisation thickness, wherein the reduction in metallisation thickness reduction is achieved with just one photolithography mask and a wet or dry removal, e.g. by etching. The solution disclosed thus advantageously reduces the number of lithography masks required to deliver both a thick layer in the active area and a thinner layer in the adjacent edge area of a semiconductor device such as a power MOSFET, which usefully combines characteristics of low Rds(on) and mechanical robustness.

Certain embodiments of the method may comprise the further step of configuring the second mask to define at least one member in the first portion, delimited by adjacent second portions. The member so defined is advantageous for certain types of semiconductor devices requiring at least one gate member in the edge termination area, such as MOSFETs.

In variants of such embodiments, the configuration of the second mask may further comprise defining a second member in the first portion. The second member so defined is advantageous for certain types of semiconductor devices requiring at least one gate member and at least one source member in the edge termination area, with the gate member located intermediate the source member and the layer adjacent the first portion.

Certain embodiments of the method may comprise the further step of configuring the first mask to define the or each member with a first width, wherein the configuration of the second mask further comprising defining at least one of the or each member with a second width larger than the first width.

The selective etching proposed in this embodiment can provide, in the context of any edge area configured with at least one gate member, a gate busbar which retains its full metal thickness, identical to the thickness of the active area of the device, and which minimises the impact of a thinner metallisation layer on the gate resistance R_{G} of the device.

The selective etching proposed in this embodiment can also provide, in the context of any edge area configured with gate and source members, both a gate busbar and a source busbar which contribute to reducing passivation cracks and pattern shift, as both retain thicker metal at their centre for best conductivity, while keeping thinner metal around the periphery of the structure where thermomechanical stress is high. This results in minimal impact on the gate resistance R_{G}, while improving mechanical robustness of the device significantly.

In certain embodiments of the method, the step of depositing may further comprise interleaving at least one layer of a second material intermediate the substrate and the layer top surface, the interleaved layer having a respective top surface; and the step of removing metal material from the edge area may further comprises removing metal material, whereby the first portion has a thickness intermediate the substrate and the interleaved layer top surface. The interleaved layer in such embodiments constitutes a mid-layer end-point detection barrier, located intermediate the active area and the edge area.

In certain embodiments of the method, the step of depositing may further comprise interleaving a plurality of layers of a second material intermediate the substrate and the layer top surface, each interleaved layer having a respective top surface; the method comprising the further step of configuring a plurality of first masks in a sequence for staggering the edge area at each of the plurality of interleaved layers; and the step of removing metal material from the edge area further comprises removing metal material with each of the plurality of the first masks.

Each interleaved layer in such embodiments constitutes a mid-layer end-point detection barrier, located intermediate the active area and the edge area, and a step is configured at each interleaved layer in the approximation of a continuous shallow angle slope between a first second portion and the active area, to both reduce active region-to-edge region topography whilst allowing thin metallisation for the one or more member(s) in the edge area region.

In variants of such embodiments, the step of configuring a plurality of first masks may further comprise configuring at least the last first mask in the sequence to define the at least two members in the first portion.

This approach advantageously implements pattern resisting over topography on the interleaved gaps, defining the thickness of member(s) in the edge area according to a predetermined thickness between the highest and lowest interleaved layers, in order to maintain implementing flexibility for R_{G}. Subject to the number of interleaved layers, the manufacturing sequence may thus include thinning the member(s), e.g. the gate member or the gate and source busbars, down in the first one, two or more etches, in order to reduce thermomechanical stress, but preserving metallisation thickness in the following one or two etches, in order to maintain a low R_{G}.

The second material for interleaved layer(s) may be selected from a first group comprising Titanium, Vanadium, Chromium, Zirconium, Niobium, Molybdenum, Hafnium, Tantalum, Tungsten; or from a second group comprising Cobalt, Nickel, Copper, Rhodium, Palladium, Silver, Iridium, Platinum, Gold; or from a group comprising alloys of the first and/or second group. In variants of such embodiments, the method may comprise the further step of reacting the second material with oxygen (O₂) or with nitrogen (N₂).

In another aspect, a semiconductor device is provided, manufactured according to any of the techniques disclosed herein

Other aspects of the invention are set out in the accompanying claims.

### BRIEF DESCRIPTION OF DRAWINGS

The invention will be more clearly understood from the following description of an embodiment thereof, given by way of example only, with reference to the accompanying drawings, in which: -
Figure 1A shows a detail of a semiconductor device manufactured with methods of the prior art.
Figure 1B shows the equivalent detail of Figure 1A in a semiconductor device manufactured according to the invention.
Figure 2 details steps of a method of manufacturing a semiconductor device according to a first embodiment.
Figure 3 illustrates stages of a semiconductor device during manufacture with a second embodiment of the method, comprising a single member in a first portion.
Figure 4 illustrates stages of a semiconductor device during manufacture with a third embodiment of the method, comprising two members in the first portion.
Figure 5 illustrates stages of a semiconductor device during manufacture with a fourth embodiment of the method, comprising a member with varying width in the first portion.
Figure 6 illustrates stages of a semiconductor device during manufacture with a fifth embodiment of the method, comprising two members with varying width in the first portion.
Figure 7 details steps of another embodiment of a method of manufacturing a semiconductor device, including one or more interleaved layers.
Figure 8 illustrates stages of a semiconductor device during manufacture with a single interleaved layer according to the method of Figure 7.
Figure 9 illustrates stages of a semiconductor device during manufacture with several interleaved layers according to the method of Figure 7.

### DETAILED DESCRIPTION OF DRAWINGS

There will now be described by way of example specific modes contemplated by the inventors. In the following description and accompanying figures, numerous specific details are set forth in order to provide a thorough understanding, wherein like reference numerals designate like features. It will be readily apparent to one skilled in the art, that the present invention may be practiced without limitation to these specific details. In other instances, well known methods and structures have not been described in detail, to avoid obscuring the description unnecessarily.

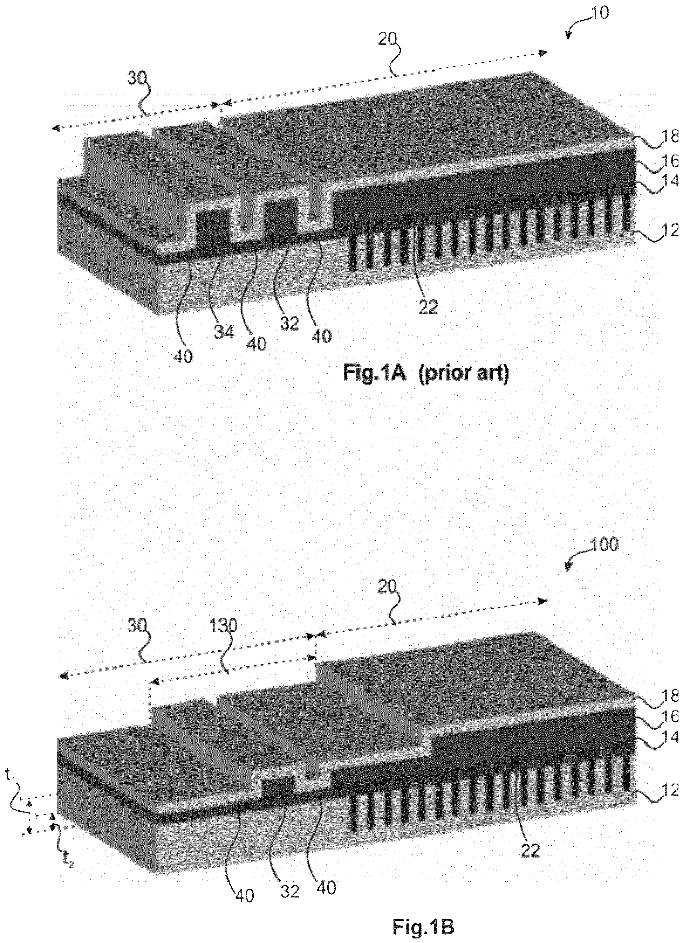

With reference to Figure 1A initially, a detail of a semiconductor device 10 manufactured with methods of the prior art is shown in a cross-sectional perpective. The semiconductor device 10 comprises, in cross-section, a substrate 12 optionally covered by an inter-layer-dielectric (`ILD') layer 14, onto a top surface of which a single metallic layer 16 is deposited, typically of aluminum copper (AlCu), in a particular thickness of e.g. 3 µm. The deposition may be performed with any technique known to the skilled reader, for example a physical vapour deposition (`PVD') technique that is well-known in the particular field of semiconductor manufacturing, implemented as either sputtering or evaporation. A photolithography process as described in the next paragraph is optionally applied to the metallic layer 16, then a passivation layer 18 such as Si3N4, SiO2 or a combination thereof is applied to the top surface of the device 10.

The detail shown in Figure 1A is a lateral edge region of the prior art device 10, wherein the active area 20 of the device, in the example corresponding to a source feature 22 of the semiconductor, is delimited by an edge area 30, or edge termination area, in the example comprising both a gate member 32 and a source member 34.

In prior art methods, the gate and source members 32, 34 are typically formed by masking the metallic layer 16 with a photolithography mask encoding the respective locations of the gate and source members 32, 34 relative to the active area 20, then performing a wet or dry etching operation to remove metallic material from the layer 16 down to the ILD layer 14 according to the mask, accordingly wherein interstitial portions 40 of the metallic layer 16 are fully removed in the edge area 30, respectively between the edge of the active area 20 and the gate member 32, between the gate and source members themselves, and from the source member 34 to the edge of the substrate 12. Accordingly both the active area 20 and the gate and source members 32, 34 of the prior art semiconductor device 10 exhibit a same thickness, i.e. vertical height relative to the surface of the substrate and ILD layers 12, 14.

The inventors have observed empirically, from a comparison of devices respectively configured with 2µm and 3 µm AlCu metallic layers and examined after 500 cycles on TMCL (dT=205 °C), that during thermal cycling, metal layers 16 that are thinner develop fewer cracks in the passivation layer 18 in extreme corners and at metal edges of the device 10. The higher incidence of passivation cracking has been attributed to a phenomenon known as the 'yield strength' of the material, wherein it begins to deform plastically, causing the material to detach or delaminate itself from its neighbouring materials, and accordingly bear thermomechanical stresses in the device alone.

The inventors have accordingly posited that there exists a dimensionless quantity S, expressed as a function of Young's modulus, the yield strength, the coefficient of thermal expansion, Poisson's ratio and the shear stress for the device's metal and silicon materials given temperatures THi and TLo, which is an indicator of thermomechanical stability with respect to crack formation when a device is thermally cycled between temperatures THi and TLo, wherein no yielding and ratcheting of AlCu will occur under TMCL and wherein the thermomechanical stress induced by TMCL will be borne by all materials making up the body of the device, i.e. the passivation 18, metal 16 and body of the device 12, for as long as S<2. That stability criterion S<2 can be enhanced by increasing the yield strength value for the metal material, which in turn depends on the shear force acting upon the material during TMCL, the width of the material and the thickness of the material.

Since the width of the material is fixed by the device's size, accordingly the parameter capable of modification is the thickness of the metallisation layer 16, and the inventors have observed, through modelling based on a normalised thickness of 3 µm as commonly used in semiconductor devices, that a reduction of AlCu from 3 µm to 2 µm should result in a 50% increase in the yield strength value for the metal material, whilst a reduction to 1 µm should result in a 300% increase.

Accordingly the inventors have devised a novel method of manufacture to reduce the thickness of the metallisation layer 16 in peripheral edge regions of semiconductor devices, an example embodiment of which is shown in Figure 1B and which, for ease of reference, mirrors the detail and perspective of Figure 1A, wherein like numerals correspond to like features.

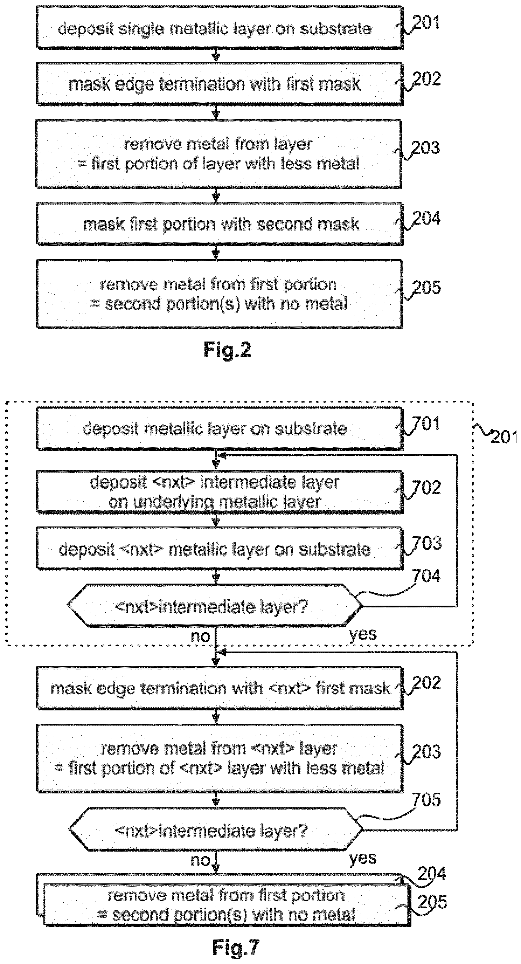

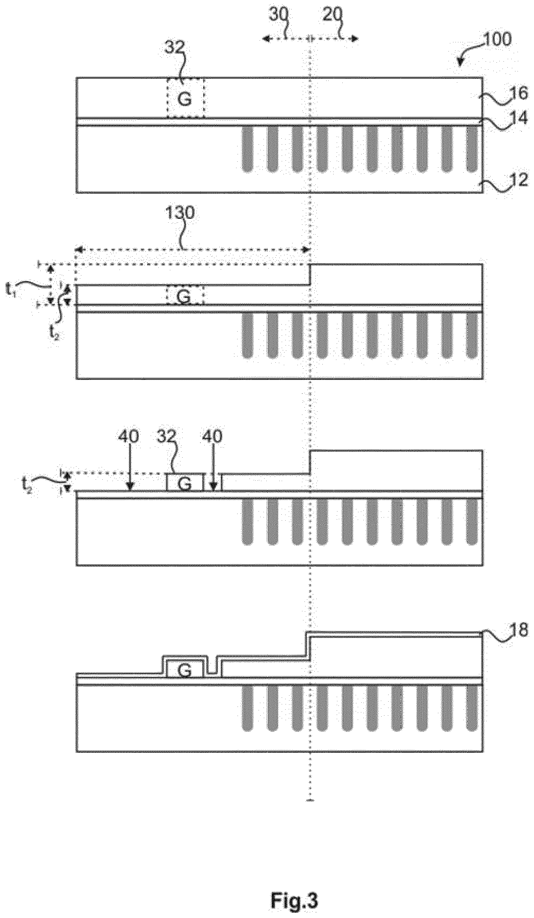

The semiconductor device 100 of Figure 1B comprises, in cross-section, the same substrate 12 optionally covered by an ILD layer 14, onto a top surface of which a single metallic layer 16 is deposited at step 201, for example by sputterring a metal alloy in a thickness t₁ of 3 µm again. A photolithography process according to the method of the invention, as described hereinafter with reference to Figure 2 and illustrated in Figure 3 for the semiconductor device 100 of Figure 1B, is then applied to the metallic layer 16, then a passivation layer 18 such as Si3N4, SiO2 or a combination thereof is again applied to the top surface of the device 100.

The detail shown in Figure 1B is again a lateral edge region of the device 100, wherein the active area 20 is still delimited by an edge area 30, or edge termination area, in the example comprising a single gate member 32.

According to the method, after depositing the metallic layer 16 at step 201 and before forming the gate member 32, the edge area 30 of the metallic layer 16 is masked with a first lithography mask at step 202. A thickness of metallic material is then removed from the edge area according to the first mask, for instance with a dry or wet etching process, whereby a first portion 130 of the edge area has a remaining thickness t₂ intermediate the substrate 12 (optionally covered by the ILD layer 14) and the top surface of the metallic layer 16, i.e. less than the thickness t₁ of 3 µm of the metallic layer 16 deposited at step 201, for example 1 or 2 µm. The first portion 130 extends from the edge of the active area 20 immediately adjacent the edge area 30, i.e. the location at which the metallic layer 16 transitions from its full thickness t₁ to the reduced thickness t₂ and effectively forms a step, toward the device's lateral edge. The first portion 130 may have a length in the range 20 to 50 µm.

The topography of the edge area 30 in this first example device 100 is then formed by masking the first portion 130 of the edge area with a second lithography mask at step 203, then removing material from the metallic layer 16 in the first portion 130 over the remaining thickness t₂, i.e. down to the top surface of the substrate layer 12 (or ILD layer 14 when present) according to the second mask at step 204, accordingly wherein one or more second portions 40 of the metallic layer 16 in the edge area 30 are fully removed. In this first example including a gate member 32, a second portion 40 is located between a certain distance from the step at the edge of the active area 20 and a side of the gate member 32 facing the active area 20, and a further second portion is located from the opposed side of the gate member 34 to the edge of the substrate 12.

The active area 20 maintains its original thickness t₁ of deposited metallic layer 16 and is thus optimised for a reduced Rds(on). This region will typically be inside the active area of the device 100 and will extend approximately up to the edge of the edge termination structure. The edge area 30, including the gate member 32 in this example, is advantageously configured with a thinner thickness t₂, and accordingly optimised for metallic yield strength.

The step intermediate the active and edge areas 20, 30 may still be prone to passivation cracking. However, in the event of a passivation crack appearing at the edge of the active area 20, the tensile energy will be released at the foot of the step, wherein any resulting propagating cracks will disperse over the edge area 30 which, given its length of 20 to 50 µm, will absorb even the longest of cracks seen in practice. Inter-areas propagating cracks are considered benign because they are transmitted between parts of the same metal structure 16 without penetration to underlying layers. Semiconductor devices manufactured with the present method are accordingly exceedingly robust against passivation cracks and uncontrolled thermomechanical energy release.

Skilled persons will appreciate that the method of the invention may be practiced without configuring the the edge area 30, without any other topography than the edge of the first portion 130 most distal the active area 20, i.e. the location at which the metallic layer 16 transitions from its reduced thickness t₂ down to the top surface of the substrate layer 12 (or ILD layer 14 when present), thus wherein a single second portion 40 of the edge area 30 most distal the active area 20 is free of deposited metallic material after step 204.

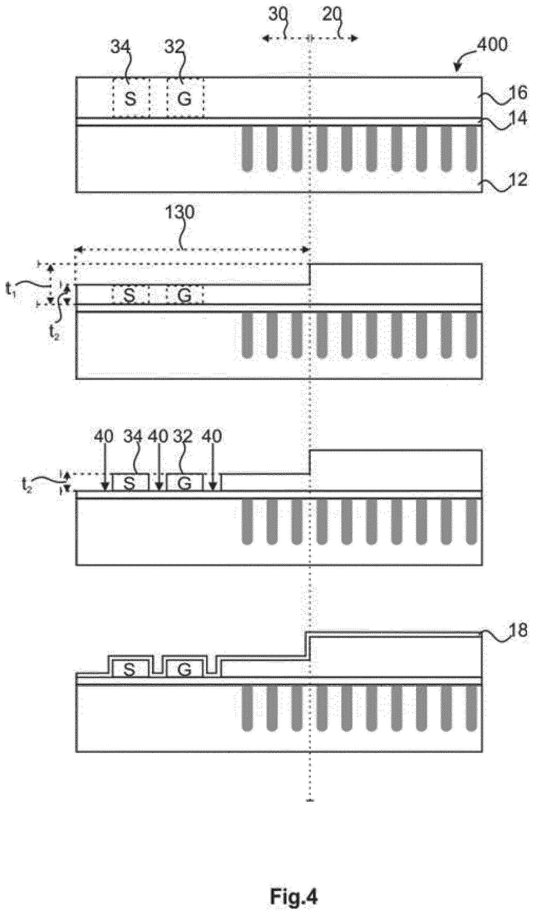

Skilled persons will appreciate likewise that the method of the invention may be practiced with many different configurations for the edge area 30, subject to the properties and functionality desired for the target semiconductor device. Accordingly, variant embodiments of the method as first described with reference to Figure 2 are now proposed and described with reference to Figures 4 to 6, wherein like numerals correspond to like features.

In the embodiment of the device 100 shown in Figures 1B and 3, the edge area 30 was configured with a single gate member 32. In an embodiment of the method, illustrated in Figure 4, the edge area 30 of the semiconductor device 400 is configured with two members, respectively a gate member 32 and a source member 34. The metallic layer 16 is deposited at step 201, the first mask is applied at step 202 and material is removed from the metallic layer 16 according to the first mask at step 203 as previously described.

In this embodiment, the second mask of step 204 is further configured to define the second source member 34 in addition to the first gate member 32 whereby, after applying the second mask to the first portion 130 at step 204 and removing material therefrom removed over the remaining thickness t₂ according to the second mask at step 205, a second portion 40 is located between a certain distance from the step at the edge of the active area 20 and a side of the gate member 32 facing the active area 20, a further second portion is located from the opposed side of the gate member 32 and a side of the source member 34 facing the active area 20, and another second portion is located from the opposed side of the source member 34 to the edge of the substrate 12. The edge area 30, including both gate and source members 32, 34 in this example, is again advantageously configured with a thinner thickness t₂, and thus optimised for metallic yield strength.

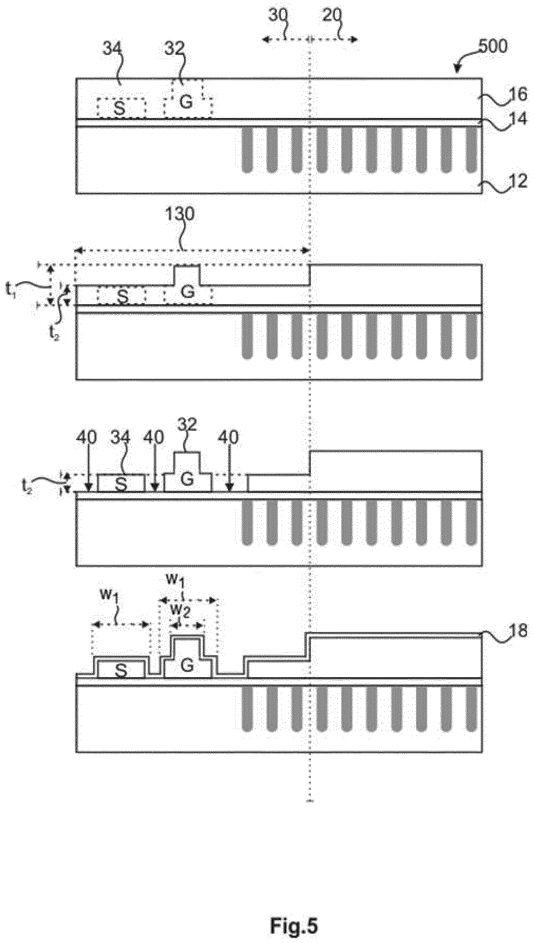

In another embodiment of the method, illustrated in Figure 5, the edge area 30 of the semiconductor device 500 is again configured with a gate member 32 and a source member 34. Relative to the source member 34 of reduced thickness t₂, the gate member 32 is designed as a busbar for enhancing the gate resistance property R_{G} of the secomiconductor device 500, and preferably retains the full thickness t₁ of the metallic layer 16 as deposited at step 201 for this purpose.

In this embodiment, the first mask of step 202 is additionally configured to define an upper portion of the gate member 32 with a first width w₁ and the second mask of step 204 is additionally configured to both define the second source member 34 and to define a lower portion of the gate member 34 with a second width w₂ larger than w₁, noting that the second source member 34 may be configured with the same larger width w₂.

The metallic layer 16 is deposited at step 201, the first mask is applied at step 202 and material is removed from the metallic layer 16 according to the first mask at step 203, thus on either side of the upper portion of the gate member 32 with a first width w₁. The second mask is applied at step 204 and material is removed over the remaining thickness t₂ in the first portion 130 according to the second mask at step 205, thus wherein a second portion 40 is located respectively on a side of the lower portion of the gate member 32 with a larger width w₂, centrally of the opposed side of the lower portion of the gate member 32 and a side of the source member 34, and on the opposed side of the source member 34. The edge area 30, including both gate and source members 32, 34 is again advantageously configured with a thinner thickness t₂, and thus optimised for metallic yield strength, however wherein the gate member 32 has both a full thickness t₁ and a wider lower portion providing thicker metal at its centre for enhanced conductivity.

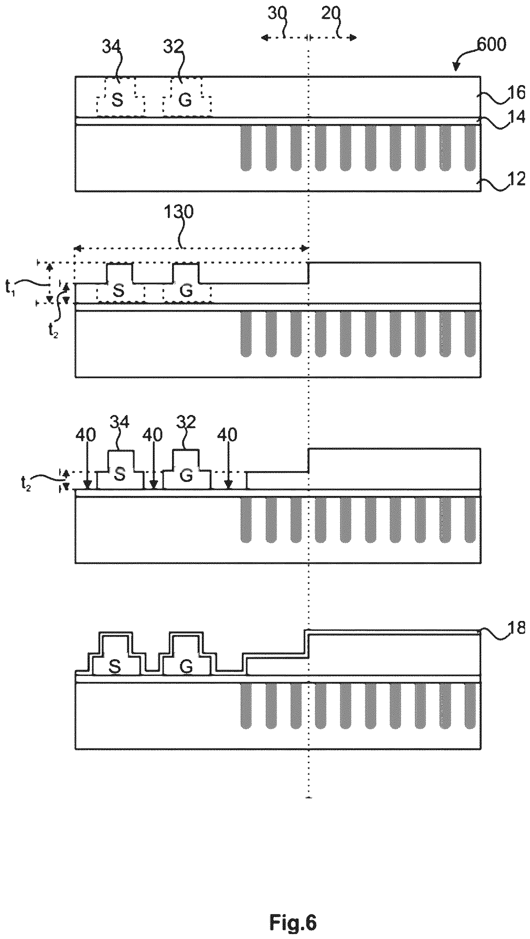

In another embodiment of the method, illustrated in Figure 6, the edge area 30 of the semiconductor device 600 is again configured with a gate member 32 and a source member 34 wherein, in this embodiment, both members are designed as busbars, each the full thickness t₁ of the metallic layer 16 as deposited at step 201. In this embodiment, the first mask of step 202 is additionally configured to define an upper portion of both the gate and source members 32, 34 with the first width w₁ and the second mask of step 204 is additionally configured to both define a lower portion of each of the gate and source members 32, 34 with the second width w₂ larger than w₁.

The metallic layer 16 is deposited at step 201, the first mask is applied at step 202 and material is removed from the metallic layer 16 according to the first mask at step 203, thus on either side of the respective upper portion of each of the gate and source members 32, 34. The second mask is applied at step 204 and material is removed over the remaining thickness t₂ in the first portion 130 according to the second mask at step 205, whereby second portions 40 are located as previously described with reference to Figure 5.

The edge area 30, including both gate and source members 32, 34 is still advantageously configured, at least partially in this embodiment, with a thinner thickness t₂, and thus optimised for metallic yield strength, and each of the gate and source members 32 has both a full thickness t₁ and a wider lower portion providing thicker metal at its centre, resulting in a device 600 combining enhanced conductivity and improved mechanical robustness, as the wider lower portion of each busbar 32, 34 enables pattern shift and passivation cracks to be minimised in the edge area 30.

Further variants of the method consider interleaving one or more layers of a second material within the metallic layer 16, wherein the or each such interleaved layer acts as an end-point detection layer and allows better control of metallisation thickness in the edge termination area 30. Although slightly more complex than previous embodiments, this approach advantageously maintains the advantages of the preceding embodiments, namely retaining the original thickness t₁ of metallisation for optimal spreading resistance in the power region 20 of the device and providing a lesser thickness t₂ of metallisation in its edge region 30 for enhanced mechanical robustness and, subject to the number of interleaved layers, also allows the topography of the transition between both regions to be smoothed, with steps at each intermediary layer approximating a continuous shallow angle slope.

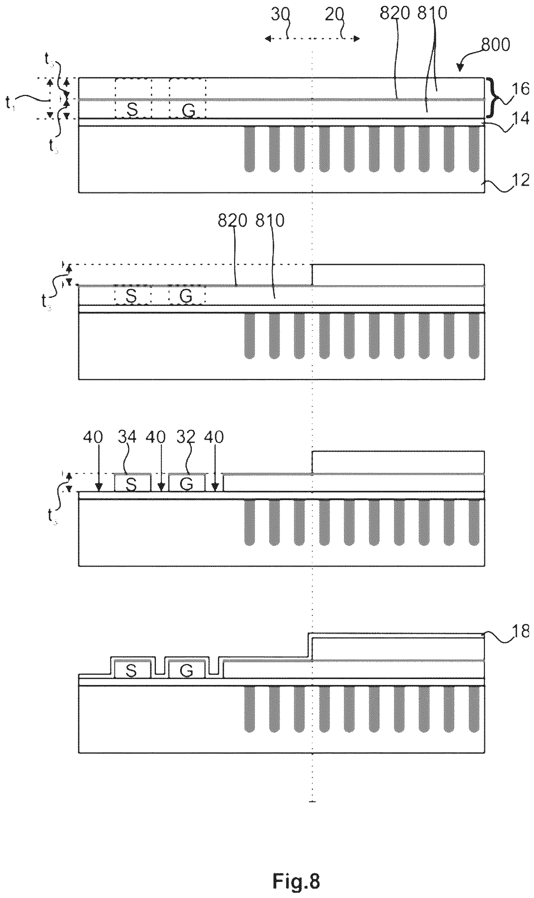

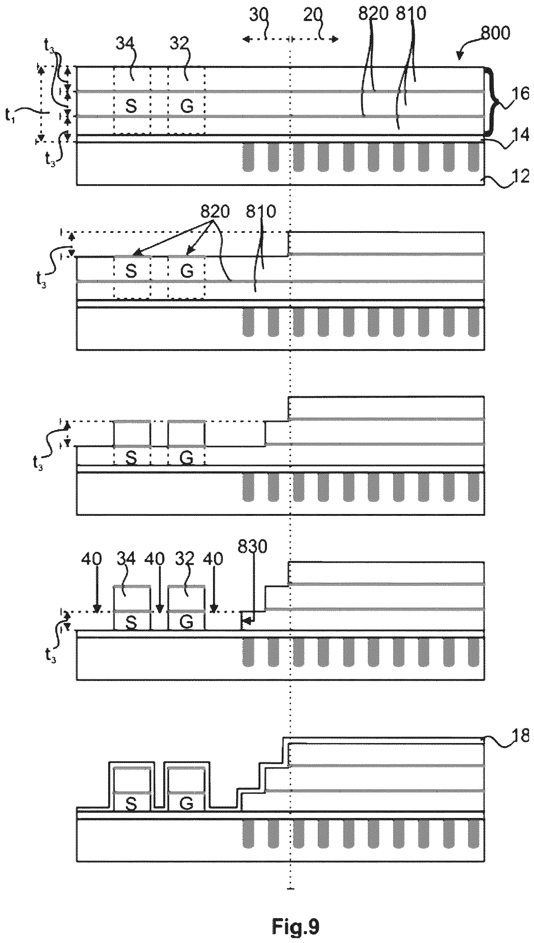

A general embodiment of such a variant is now described by reference to Figure 7, with specific examples respectively illustrated in Figures 8 and 9, wherein like numerals correspond to like features. The method step of deposition 201 in such variants comprises a series of sub-steps, including at least a first sub-step 701 of depositing an initial sub-layer 810 of metallic material onto the substrate 12 (or ILD layer 14 atop same), in a thickness t₃ that is a fraction of the full thickness t₁ of metallisation desired for the active area 20, and which may correspond to the reduced thickness t₂ described in previous embodiments, in the example case of a single interleaved layer. At least one instance of a next sub-step 702 involves depositing the, or the first, interleaving layer 820 of second material, in the example titanium (Ti) or a titanium nitride (TiN) alloy, in as minimal a thickness as permitted by the depositing technique used. At least one instance of a next sub-step 703 involves depositing a next sub-layer 810 of metallic material onto the deposited layer of second material 820, in substantially the same thickness t₃ as the initial sub-layer, or another.

A question is then asked at sub-step 704, about whether the interleaved metallisation design for the semiconductor device 800 requires a further interleaved layer 820 of second material. In the affirmative, the method returns to sub-step 702, wherein a further interleaving layer 820 of second material is deposited, whence the next sub-layer 810 of metallic material gets deposited onto the second-deposited layer of second material 820 at step 703, and so on and so forth. Alternatively, or eventually, the last-deposited sub-layer 810 of metallic material achieves the full thickness t₁ of metallisation desired for the active area 20 and the question of sub-step 704 is answered negatively, wherein the layer 16 comprises one or more interleaved layers 820 of second material.

Control proceeds to the masking of step 202 with a first lithography mask as previously described, then the removal of material from the metallic layer 16 in the edge area 30 according to same at step 203. Skilled persons will appreciate that, subject to the desired properties of the semiconductor device, the masking and removal of steps 202, 2023 may either include or exclude the interleaving layer 820 underlying the volume of metallic material removed. In the example illustrated in Figure 8, the interleaving layer 820 is maintained uniformly within the first portion 130, including atop the gate and source members 32, 34 of reduced thickness t₂, accordingly the first portion has a thickness intermediate the substrate and the interleaved layer top surface. In contrast, in the example illustrated in Figure 9, the interleaving layer 820 is maintained atop gate and source members 32, 34 but not in other aspects of the first portion 130.

Furthermore, since the metallic layer 16 may comprise more than one interleaved layer 820, then subject to the thickness t₁ of the metallic layer 16 prior to first masking and the topography desired for the edge area 30 of the device 800, the method may require a number of first masks, the number dependent upon the number of interleaved layers 820 within the metallic layer 16, and the configuration of each first mask in the sequence thereof, optionally defining the staggering of the edge area 30 at each of the plurality of interleaved layers adjacent the active 20, as illustrated in Figure 9.

Skilled persons will appreciate that this variant is also fully compatible with earlier-described embodiments, for example wherein one or more members 32, 34 can be defined within the first portion 130 of the edge area, with a reduced thickness t₃ as illustrated in Figure 8, or with an intermediate thickness as illustrated in Figure 9, subject to configuring at least the last first mask in the sequence to define the or each members in the first portion 130, before material is fully removed with the second mask in second portions 40, down to the substrate 12 (or ILD layer 14).

Suitably, the method accordingly queries next, at additional step 705, whether there is a further interleaved layer 820 in the metallic layer 16, i.e. an interleaved layer 820 within a remaining thickness of metallic layer 16 that is yet to be removed, requiring a further masking and removal cycle of steps 202, 203 and a corresponding and respective further first mask for same. In the affirmative, the method returns to step 202, wherein a further first lithography mask is applied to the edge area 30, then further material is removed from the metallic layer 16 remaining in the first portion 130 according to same at step 203, and so on and so forth.

Alternatively, or eventually, the last-removed sub-layer 810 of metallic material achieves the reduced level of thickness t₃ of metallisation desired for the edge area 20 and the question of sub-step 705 is answered negatively, wherein the method proceeds to the masking of step 204 with a second lithography mask as previously described, then the removal of material from the metallic layer 16 in the first portion 130 according to same at step 205. Second portions 40 are again located between a certain distance from the lowest step 830 of the edge area 30 and a first member 32, intermediate any adjacent members, and from the opposed side of the member 34 most distal the active area 20 to the edge of the substrate 12.

The methods of manufacturing presently disclosed provide semiconductor devices with a combination of reduced Rds(on) in their active area and elevated mechanical robustness in their edge area, with predictable level of passivation crack guidance and containment. The methods of manufacturing presently disclosed are useable with all semiconductor devices made with known technologies, e.g. Silicon (Si) or a compound semiconductor containing elements from groups III and V in the periodic table (a "III-V compound"), for example Silicon carbide (SiC), Gallium nitride (GaN), with passivation layers that are prone to mechanical fatigue and failure due to cracks propagating to underlying layers through thermal mismatch between dissimilar materials making up the device. Such semiconductor devices include variously power devices (MOSFETs, bipolar junction transistors (BJTs), insulated-gate bipolar transistors (IGBTs) and the like) and integrated power devices (Driver and MOSFET modules (DrMOS), Temperature and Overload Protected Field Effect Transistors (TopFET) and the like).

In the specification the terms "comprise, comprises, comprised and comprising" or any variation thereof and the terms include, includes, included and including" or any variation thereof are considered to be totally interchangeable and they should all be afforded the widest possible interpretation and vice versa. The invention is not limited to the embodiments hereinbefore described but may be varied in both construction and detail.

## Claims

1. A method of manufacturing a semiconductor device comprising the steps of
depositing a layer of metallic material onto a substrate, the layer having a top surface;
masking at least an edge area of the layer with a first lithography mask;
removing metallic material from the edge area according to the first mask, whereby a first portion of the edge area has a thickness intermediate the substrate and the layer top surface;
masking the first portion of the edge area with a second lithography mask; and
removing metallic material from the first portion according to the second mask, whereby at least a second portion of the edge area is free of deposited metallic material.

2. The method according to claim 1, comprising the further step of configuring the second mask to define at least one member in the first portion, wherein the or each member is delimited by adjacent second portions.

3. The method according to claim 2, wherein the at least one member defined in the first portion is a gate member.

4. The method according to claim 3, wherein at least a second member defined in the first portion is a source member.

5. The method according to any of claims 2 to 4, comprising the further step of configuring the first mask to define the or each member with a first width;
the step of configuring the second mask further comprising defining at least one of the or each member with a second width larger than the first width.

6. The method according to any of claims 1 to 5, wherein
the step of depositing further comprises interleaving at least one layer of a second material intermediate the substrate and the layer top surface, the interleaved layer having a respective top surface ; and
the step of removing metal material from the edge area further comprises removing metal material, whereby the first portion has a thickness intermediate the substrate and the interleaved layer top surface.

7. The method according to claims 1 to 5,
wherein the step of depositing further comprises interleaving a plurality of layers of a second material intermediate the substrate and the layer top surface, each interleaved layer having a respective top surface;
the method comprising the further step of configuring a plurality of first masks in a sequence for staggering the edge area at each of the plurality of interleaved layers; and
the step of removing metal material from the edge area further comprises removing metal material with each of the plurality of the first masks.

8. The method according to claim 7, wherein the step of configuring a plurality of first masks further comprises configuring at least the last first mask in the sequence to define the at least two members in the first portion.

9. The method according to claim 7 or 8, wherein the second material is selected
from a first group comprising Titanium, Vanadium, Chromium, Zirconium, Niobium, Molybdenum, Hafnium, Tantalum, Tungsten ; or
from a second group comprising Cobalt, Nickel, Copper, Rhodium, Palladium, Silver, Iridium, Platinum, Gold.

10. The method according to claim 9, wherein the second material is selected from the group comprising alloys of the first and/or second group.

11. The method according to claim 9 or 10, comprising the further step of reacting the second material with oxygen (O₂) or with nitrogen (N₂).

12. A semiconductor device manufactured with the method according to any of claims 1 to 11.

13. The semiconductor device according to claim 12, manufactured from Silicon (Si) or a III-V compound semiconductor.

14. The semiconductor device according to claim 12 or 13, selected from the group comprising MOSFETs, bipolar junction transistors (BJTs), insulated-gate bipolar transistors (IGBTs) , Driver and MOSFET modules (DrMOS), Temperature and Overload Protected Field Effect Transistors (TopFET).
